# EUROPEAN PATENT SPECIFICATION

(11) **EP 1 831 707 B1**
(45) Date of publication and mention of the grant of the patent: **09.06.2010**
(21) Application number: 05821483.4
(22) Date of filing: 22.12.2005
(51) Int. Cl.: G01R 31/312, G06K 7/00

(54) **METHOD AND APPARATUS FOR CONTACTLESS TESTING OF RFID STRAPS**
VERFAHREN UND VORRICHTUNG ZUM KONTAKTLOSEN PRÜFEN VON RFID-SCHLAUFEN
PROCEDE ET APPAREIL POUR EFFECTUER DES TESTS SANS CONTACT DE BARRETTES D'IDENTIFICATION PAR RADIO-FREQUENCE

(30) Priority: 22.12.2004 DE 102004061918
(43) Date of publication of application: 12.09.2007
(73) Proprietor: TEXAS INSTRUMENTS DEUTSCHLAND GMBH, 85356 Freising (DE)
(72) Inventor: MAYER-ZINTEL, Jürgen, 85391 Allershausen (DE); TAN, Enn, Leong, 53000 Kuala Lumpur (MY); ASLANIDIS, Konstantin, O., 85221 Dachau (DE)
(74) Representative: Holt, Michael
(86) International application number: PCT/EP2005/013912
(87) International publication number: WO 2006/066938

(56) References cited:
- FR-A- 2 817 352
- US-A- 5 072 176
- US-A1- 2001 013 783
- US-A1- 2004 160 233
- PATENT ABSTRACTS OF JAPAN vol. 2003, no. 12, 5 December 2003 (2003-12-05) & JP 2004 289462 A (TOPPAN FORMS CO LTD), 14 October 2004 (2004-10-14)

## Description

The present invention relates to a method and apparatus for batch testing of RFID straps arranged on a carrier web in a closely spaced relationship.

RFID tags consist of a chip (integrated circuit) and a planar antenna. The chip is carried on a strap for attachment on an antenna. As used herein, an RFID strap is an arrangement of two or more terminal pads on a foil such as a PET foil or paper and an RFID chip mounted on the foil and having contact bumps each in electrical contact with one of the terminal pads. In mass production of these tags, the straps are assembled with the antennas in a final bonding step. Prior to the final bonding step, the chips must be tested. In the case of RFID tags operating in the UHF frequency range, the antennas and the terminal pads of the straps are very small. Conventionally, the terminal pads of each strap are contacted with a pair of needle electrodes of a test probe. For high volume production, the handling of test fixtures with contacting test electrodes such as needles is a severe throughput limitation. Contact-less testing by RF radiation is possible, but simultaneous batch testing of multiple tags would require complex shielding techniques due to the crosstalk between the units under test.

United States Patent Application No. 2004/160233 describes an RFID device tester includes coupling elements for capacitively coupling a reader to an RFID device to be tested. The RFID device tester may be used as part of a roll-to-roll process, to individually test RFID devices on a roll of material. By utilizing short-range capacitive coupling, difficulties caused by simultaneous activation of multiple RFID devices may be reduced or avoided.

The present invention provides a method and an apparatus for contact-less testing of RFID straps and, in particular, RFID chips for the UHF frequency range. The basic idea of the invention is to use capacitive coupling between each test probe and a strap under test. This approach avoids crosstalk between the chips under test and permits batch testing, i.e. simultaneous testing of multiple chips. With the inventive method and apparatus, multiple straps can be tested in a very short period of time. For example, in a practical implementation of the invention, each batch may comprise 32 straps, and each batch is tested in about 50 ms including an indexing step of the carrier web. Even larger batches and shorter test times are envisioned. Specifically, the invention provides a method of and an apparatus for batch testing RFID straps arranged on a carrier web in a closely spaced relationship as set out in the appended claims.

Further details of the invention appear from the dependent claims and from the following description with reference to the appending drawings. In the drawings:
Fig. 1 is a schematic side view of an RFID tag batch testing arrangement according to a first embodiment;
Fig. 2 is an enlarged schematic side view of a single unit under test in the first embodiment;
Fig. 3 is a schematic side view of an RFID tag batch testing arrangement according to a second embodiment;
Fig. 4 is an enlarged schematic side view of a single unit under test in the second embodiment;
Fig. 5 is a circuit diagram illustrating the matching between a tag under test and a test head;
Fig. 6 is a schematic plan view of a single RFID strap;
Fig. 7 is a schematic side view of the RFID strap; and
Fig. 8 is a schematic plan view of a carrier web with parallel rows of closely spaced straps thereon;

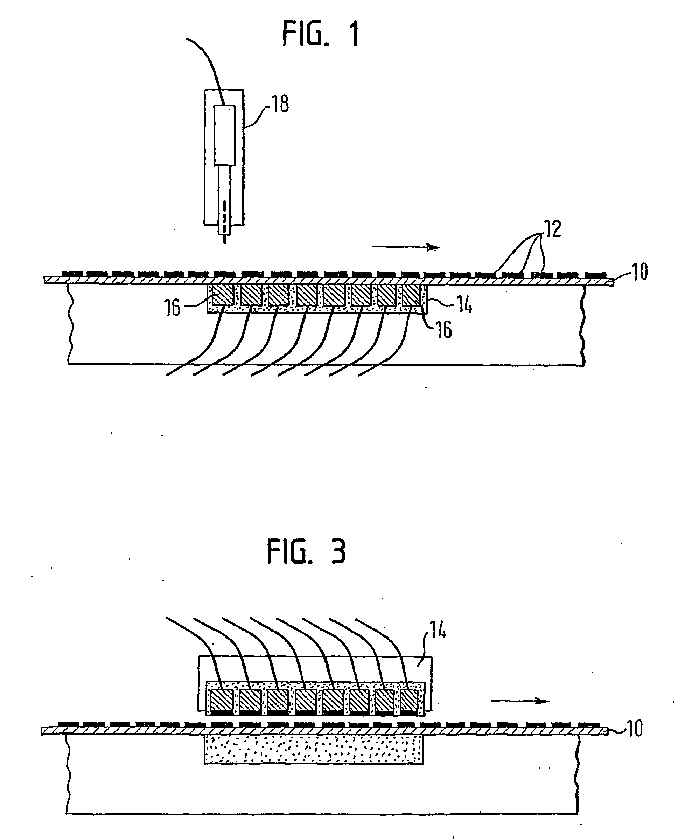

In Fig. 1, a horizontal web 10 carries multiple closely spaced RFID straps 12 which are aligned in a row or, preferably, in multiple rows. The web may be a strap foil of PET. A test head 14 includes multiple test probes 16 placed against the web 10 from beneath. The test probes 16 are arranged in test head 14 in an array that corresponds to the arrangement of the RFID straps 12 on web 10 so that each test probe 16 can be vertically aligned with a corresponding strap 12. Each test probe has a lead for connection to a common test equipment (not shown). An inking device 18 is provided to selectively mark individual straps that would not have passed a test. By applying a vacuum between the web 10 and the test head 14 the web is fixed against accidental movement and any air cushion between the test head and the web is removed to ensure reproducible test results.

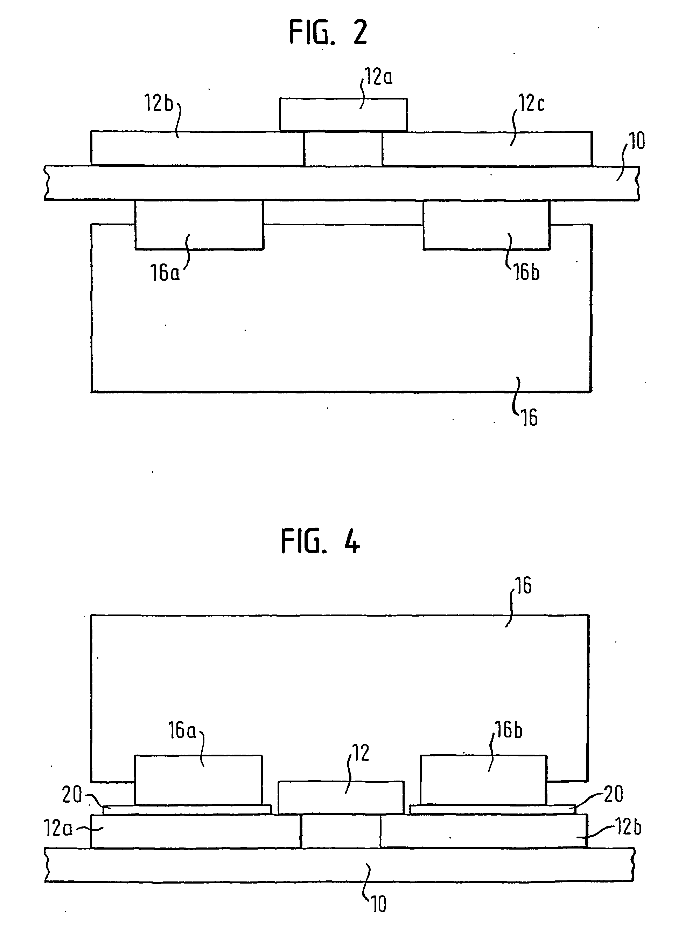

With reference to Fig. 2, each RFID strap 12 comprises a chip 12a, a first terminal pad 12b and a second terminal pad 12c, both intended for the final connection to an antenna of an RFID tag. The test probe 16 has a first test electrode 16a and a second test electrode 16b. Both test electrodes 16a, 16b are applied against the lower face of web 10 in vertical alignment with the corresponding terminal pads 12b, 12c. The web forms a dielectric between electrodes 16a, 16b and pads 12b, 12c. To eliminate residual air between the lower face of web 10 and the faces of test electrodes 16a, 16b, the test head may be pressed against web 10. Alternatively, the residual air is removed by some aspiration means (not shown). A capacitive coupling is established between each test head 14 and a corresponding strap 12 by virtue of the capacitance formed between each test electrode and terminal pad. In this embodiment, the inking device 18 (or any other marking device) does not require additional space as it is placed directly over the test head.

In the embodiment of Figs. 3 and 4, the test head 14 is arranged above web 10 and is lowered so as to place the test electrodes 16a, 16b immediately above the corresponding terminal pads 12b, 12c. To avoid a direct contact, a foil 20 of a dielectric material is interposed between the electrodes 16a, 16b and the pads 12b, 12c. The remaining arrangement is the same as in the preceding embodiment. Therefore, the coupling capacity between the test electrodes 16a, 16b and the terminal pads 12b, 12c is now independent of the material and thickness of the web 10. This allows a greater flexibility on the used web material as the matching network can remain unchanged. In this embodiment, residual air between the web 10 and the test head 14 is removed by pressing the head onto the web.

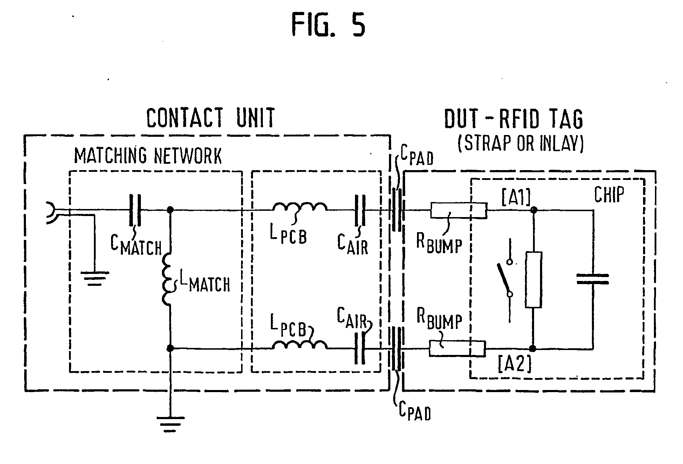

As seen in Fig. 5, a RFID strap under test (DUT, device under test) is equivalent to a circuit with an internal capacitance and (switched) resistor and includes series resistors R_{Bump} corresponding to the bump contact resistance of the chip. In the case of UHF tags that have a low Q value on the order of 5, these contact resistances can be neglected. The capacitance between each electrode-pad pair is represented by a capacitor C_{PAD}. The interface between the strap and the test probe is represented by series-connected inductive and capacitive elements L_{PCB} and C_{Air}. The test probe 16 has a matching network that consists of series capacitor C_{match} and a parallel inductor L_{match}. It should be understood that these capacitive and inductive elements are indicated symbolically, as actual implementations may be more complex. In the embodiment of Fig. 3, the matching network of the test head 14 is independent of the used web material (PET, paper, ...) and thickness.

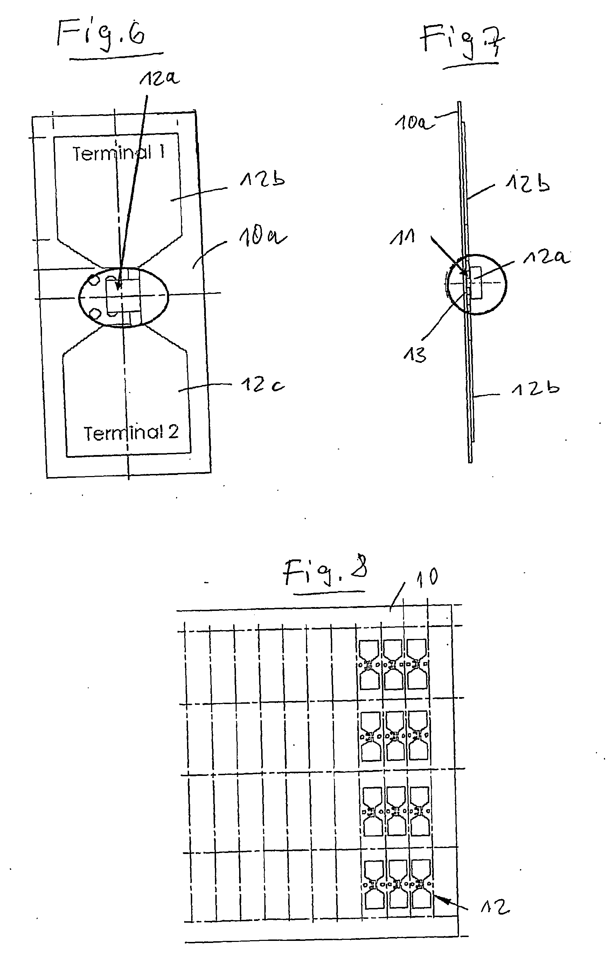

With reference to Fig. 6 and Fig. 7, an RFID strap consists of a rectangular foil 10a (which may actually be a cut section of carrier web 10) that has terminal pads 12b and 12c formed thereon, and the RFID chip 12a. Chip 12a is mounted on foil 10a with each of its contact bumps 11, 13 in electrical contact with one of the terminal pads 12b, 12c (designated in Fig. 6 as "Terminal 1" and "Terminal 2"). As shown in Fig. 6 and Fig. 7, an RFID strap after separation from the carrier web 10 is ready for attachment and connection to an antenna circuit. The antenna circuit with the RFID strap together form an RFID tag.

Fig. 8 shows four parallel rows of closely spaced RFID straps 12 on carrier web 10.

In operation, a batch of RFID straps 12, for example 32 straps in the four parallel rows on web 10, are presented simultaneously to the test head 14, and each test probe 16 is capacitively coupled with the aligned terminal pads 12b, 12c of a strap 12. Test signals are simultaneously sent from each test probe 16 to a corresponding strap 12, and response signals are received in the test probes from the straps for evaluation by the common test equipment. Any RFID strap that has not passed the test would be marked, such as by applying an ink spot with an inking device 18 or by punching. After a batch test is completed, the web 10 is indexed to present a next batch of tags to test head 14. The testing process is preferably incorporated on-line in the RFID tag production line since testing with the inventive method is fast enough.

To avoid or at least reduce any crosstalk effects, units not under test are disabled by short-connecting the corresponding terminals 16a and 16b of test head 14. The strap will not respond, and no energy is injected. In addition, an interlaced test structure is preferably used to increase the distance between the units under test.

## Claims

1. A method of batch testing RFID straps (12) arranged on a carrier web (10) in a closely spaced relationship, each RFID strap (12) including at least two terminal pads (12b, 12c) exposed on the carrier web (10) and an RFID chip (12a) with contact bumps (11, 13) each connected to one of the terminal pads (12b, 12c), comprising the steps of:
moving the carrier web (10) so as to align a plurality RFID straps (12) in a batch with a corresponding test probes (16) of a test equipment, the test probes (16) being arranged in a interlaced structure with respect to the batch of RFID straps on the carrier web (10);
moving each test probe (16) transversely to the moving direction of the carrier web (10) into close proximity with a corresponding RFID strap (12);
establishing a capacitive coupling between test electrodes (16a, 16b) on each test probe (16) and the terminal pads (12b, 12c) of a corresponding RFID strap (12),
transmitting test signals from each test probe (16) to a corresponding RFID strap (12); and
receiving response signals at each test probe (16) from a corresponding RFID strap (12).

2. The method of claim 1, wherein the carrier web (10) is indexed to successively present each batch of RFID straps (12) to the test probes (16) of the test equipment.

3. The method of claim 1 or claim 2, wherein the plurality of RFID straps (12) in each batch are tested simultaneously.

4. The method of according to any of claims 1 to 4, wherein the test probes (16) are moved with said test electrodes (16a, 16b) into contact with a face of the carrier web (10) opposite a face on which the straps (12) are attached, the carrier web (10) being used as a dielectric.

5. The method of according to any of claims 1 to 4, wherein the test probes (16) are moved with said test electrodes (16a, 16b) against the terminal pads (12b, 12c) of the straps (12) and a dielectric foil (20) is interposed between each test electrode (16a, 16b) and each terminal pad (12b, 12c).

6. The method according to any of claims 1 to 5, wherein the test probes (16) are capacitively and inductively matched with an equivalent circuit represented by each of the RFID straps (12).

7. An apparatus for batch testing RFID straps (12) arranged on a carrier web (10) in a closely spaced relationship, each RFID strap (12) including a pair of terminal pads (12b, 12c) exposed on the carrier web (10); and an RFID chip (12a) with contact bumps (11, 13) each connected to one of said terminal pads (12b, 12c); comprising
a test head (14) that has a plurality of test probes (16) arranged in an array, each test probe (16) having a pair of test electrodes (16a, 16b) adapted to be aligned with the terminal pads (12b, 12c) of a corresponding RFID strap (12) of the batch;
means for indexing the carrier web (10) so as to successively expose batches of RFID straps (12) to the test head (14); and
means for moving each test probe (16) transversely to the moving direction of the carrier web (10) into close proximity with the corresponding RFID strap (12) of the batch;
**characterized in that**
the array of test probes (16) has an interlaced structure in relation to a plurality of RFID straps (12) of a batch on the carrier web (10) and that a capacitive coupling is established between each pair of test electrodes (16a, 16b) in a test probe (16) and the pair of terminal pads (12b, 12c) of a corresponding RFID strap (12).

8. The apparatus of claim 7, wherein the test head (14) is adapted to be moved against a face of the carrier web (10) opposite a face that carries the RFID straps (12), the web (10) being used as a dielectric.

9. The apparatus of claim 7, wherein the test head (14) is adapted to be moved against a face of the carrier web (10) that carries the RFID straps (12), a dielectric foil (20) being interposed between each pair of test electrodes (16a, 16b) and a corresponding pair of terminal pads (12b, 12c).

10. The apparatus of any of claims 7 to 9, wherein each test probe (16) includes a matching circuit with at least a capacitive element (C_{MATCH}) and an inductive element (L_{MATCH}) for capacitive and inductive matching with an equivalent circuit represented by each RFID strap (12).

## Patentansprüche

1. Verfahren zur chargenweisen Prüfung von RFID-Streifen (12), die zueinander dicht gepackt auf einer Trägermatrix (10) angeordnet sind, wobei jeder RFID-Streifen (12) zumindest zwei Anschlussflächen (12b, 12c), die auf der Trägermatrix (10) angeordnet sind, und außerdem einen RFID-Chip (12a), dessen Kontakte (12, 13) jeweils mit einer der Anschlussflächen (12b, 12c) verbunden ist, aufweist, die folgenden Schritte umfassend:
Bewegen der Trägermatrix (10), so dass eine Vielzahl von RFID-Streifen (12) einer Charge und die korrespondierenden Prüfsonden (16) einer Prüfeinheit relativ zueinander ausgerichtet sind, wobei die Prüfsonden (16) in einer versetzten Struktur relativ zu der auf der Trägermatrix (10) angeordneten Charge von RFID-Streifen (12) angeordnet sind,
Bewegen jeder Prüfsonde (16) schräg zu der Bewegungsrichtung der Trägermatrix (10) in eine nahe Umgebung eines zugehörigen RFID-Streifens (12),
Aufbauen einer kapazitiven Kopplung zwischen den Testelektroden (16a, 16b) einer jeden Prüfsonde (16) und den Anschlussflächen (12b, 12c) eines korrespondierenden RFID-Streifens (12),
Übertragen von Testsignalen von jeder Prüfsonde (16) auf einen zugehörigen RFID-Streifen (12) und
Empfangen von Antwortsignalen des zugehörigen RFID-Streifens (12) an jeder der Prüfsonden (16).

2. Verfahren nach Anspruch 1, wobei die Trägermatrix (10) indiziert wird, um den Prüfsonden (16) der Prüfeinheit nacheinander jede Charge der RFID-Streifen (12) anzubieten.

3. Verfahren nach Anspruch 1 oder Anspruch 2, wobei die Vielzahl von RFID-Streifen (12) einer Charge gleichzeitig getestet werden.

4. Verfahren nach einem der Ansprüche 1 bis 4, wobei die Prüfsonden (16) so bewegt werden, dass die Testelektroden (16a, 16b) mit einer Oberfläche der Trägermatrix (10) in Kontakt treten, welche derjenigen Seite, auf welche die RFID-Streifen (12) aufgesetzt sind, entgegengesetzt ist, wobei die Trägermatrix (10) als Dielektrikum benutzt wird.

5. Verfahren nach einem der Ansprüche 1 bis 4, wobei die Testelektroden (16a, 16b) der Prüfsonden (16) gegen die Anschlussflächen (12b, 12c) der RFID-Streifen (12) gefahren werden und eine dielektrische Folie (20) zwischen jede Testelektrode (16a, 16b) und jede Anschlussfläche (12b, 12c) positioniert wird.

6. Verfahren nach einem der Ansprüche 1 bis 5, wobei die Prüfsonden (16) kapazitiv und induktiv an einen Ersatzschaltkreis angepasst werden, der durch die entsprechenden RFID-Streifen (12) vorgegeben ist.

7. Vorrichtung zur chargenweisen Prüfung von RFID-Streifen (12), die zueinander dicht gepackt auf einer Trägermatrix (10) angeordnet sind, wobei jeder RFID-Streifen (12) ein Paar Anschlussflächen (12b, 12c), welche auf der Trägermatrix (10) angeordnet sind, und einen RFID-Chip (12a) mit Kontakten (12, 13), die jeweils mit einer der Anschlussflächen (12b, 12c) verbunden sind, aufweist, die Vorrichtung zur chargenweisen Prüfung umfassend:
einen Testkopf (14), der eine Vielzahl von in einem Array angeordneten Prüfsonden (16) umfasst, wobei jede der Prüfsonden (16) ein Paar Testelektroden (16a, 16b) aufweist, die derart ausgestaltet sind, dass diese zu den Anschlussflächen (12b, 12c) eines zugehörigen RFID-Streifens (12) der Charge ausgerichtet werden können,
eine Einheit zur Indizierung der Trägermatrix (10), um aufeinanderfolgende Chargen von RFID-Streifen (12) dem Testkopf (14) anbieten zu können und
eine Einheit zum Verfahren der Prüfsonde (16) quer zu der Bewegungsrichtung der Trägermatrix (10), wobei die Prüfsonde (16) in eine nahe Umgebung des zugehörigen RFID-Streifens (12) der Charge gebracht wird,
**dadurch gekennzeichnet, dass**
das Array von Prüfsonden (16) relativ zu der auf der Trägermatrix (10) angeordneten Vielzahl von RFID-Streifen (12) einer Charge eine versetzte Struktur aufweist, wobei eine kapazitive Kopplung zwischen jedem Paar Testelektroden (16a, 16b) einer Prüfsonde (16) und dem Paar Anschlussflächen (12b, 12c) eines zugehörigen RFID-Streifens (12) hergestellt wird.

8. Vorrichtung nach Anspruch 7, wobei der Testkopf (14) derart ausgestaltet ist, dass dieser gegen eine Oberfläche der Trägermatrix (10) gefahren wird, die derjenigen Oberfläche, auf welche der RFID-Streifen (12) aufgesetzt ist, gegenüberliegt, wobei die Trägermatrix (10) als Dielektrikum benutzt wird.

9. Vorrichtung nach Anspruch 7, wobei der Testkopf (14) derart ausgestaltet ist, dass dieser gegen eine Oberfläche der Trägermatrix (10) gefahren werden kann, welche den RFID-Streifen (12) trägt, wobei eine dielektrische Folie (20) zwischen jedes Paar Testelektroden (16a, 16b) und ein zugehöriges Paar Anschlussflächen (12b, 12c) positioniert wird.

10. Vorrichtung nach einem der Ansprüche 7 bis 9, wobei jede Prüfsonde (16) eine Abstimmschaltung mit zumindest einem kapazitiven Element (CMATCH) und einem induktiven Element (LMATCH) umfasst, wobei die Abstimmschaltung zur kapazitiven und induktiven Anpassung an einen Ersatzschaltkreis, der durch den RFID-Streifen (12) vorgegeben ist, dient.

## Revendications

1. Procédé destiné à essayer par lots des bandes RFID (12) disposées sur une bande continue support (10) selon une relation de proximité immédiate, chaque bande RFID (12) comprenant au moins deux plages de bornes (12b, 12c) exposées sur la bande continue support (10) et une puce RFID (12a) avec des bosses de contact (11, 13), chacune d'elles étant connectée à l'une des plages de bornes (12b, 12c), comprenant les étapes consistant à :
déplacer la bande continue support (10) de manière à aligner une pluralité de bandes RFID (12) dans un lot avec des sondes d'essai correspondantes (16) d'un équipement d'essai, les sondes d'essai (16) étant disposées selon une structure entrelacée par rapport au lot de bandes RFID sur la bande continue support (10) ;
déplacer chaque sonde d'essai (16) de manière transversale par rapport à la direction de déplacement de la bande continue support (10) à proximité immédiate d'une bande RFID (12) correspondante ;
établir un couplage capacitif entre des électrodes d'essai (16a, 16b) sur chaque sonde d'essai (16) et les plages de bornes (12b, 12c) d'une bande RFID (12) correspondante,
émettre des signaux d'essai à partir de chaque sonde d'essai (16) vers une bande RFID (12) correspondante ; et
recevoir des signaux de réponse au niveau de chaque sonde d'essai (16) en provenance d'une bande RFID (12) correspondante.

2. Procédé selon la revendication 1, dans lequel la bande continue support (10) est indexée de façon à présenter de manière successive chaque lot de bandes RFID (12) aux sondes d'essai (16) de l'équipement d'essai.

3. Procédé selon la revendication 1 ou la revendication 2, dans lequel la pluralité de bandes RFID (12) dans chaque lot sont examinées de manière simultanée.

4. Procédé selon l'une quelconque des revendications 1 à 4, dans lequel les sondes d'essai (16) sont déplacées avec lesdites électrodes d'essai (16a, 16b) en contact avec une face de la bande continue support (10) opposée à une face sur laquelle les bandes (12) sont fixées, la bande continue support (10) étant utilisée en tant que diélectrique.

5. Procédé selon l'une quelconque des revendications 1 à 4, dans lequel les sondes d'essai (16) sont déplacées avec lesdites électrodes d'essai (16a, 16b) contre les plages de bornes (12b, 12c) des bandes (12) et une feuille diélectrique (20) est interposée entre chaque électrode d'essai (16a, 16b) et chaque plage de bornes (12b, 12c).

6. Procédé selon l'une quelconque des revendications 1 à 5, dans lequel les sondes d'essai (16) sont adaptées de manière capacitive et inductive avec un circuit équivalent représenté par chacune des bandes RFID (12).

7. Appareil destiné à essayer par lots des bandes RFID (12) disposées sur une bande continue support (10) selon une relation de proximité immédiate, chaque bande RFID (12) comprenant une paire de plages de bornes (12b, 12c) exposées sur la bande continue support (10), et une puce RFID (12a) avec des bosses de contact (11, 13), chacune d'elles étant connectée à l'une desdites plages de bornes (12b, 12c) ; comprenant :
une tête d'essai (14) qui présente une pluralité de sondes d'essai (16) disposées en une matrice, chaque sonde d'essai (16) présentant une paire d'électrodes d'essai (16a, 16b) adaptées de manière à être alignées avec les plages de bornes (12b, 12c) d'une bande RFID (12) correspondante du lot ;
des moyens destinés à indexer la bande continue support (10) de façon à exposer de manière successive des lots de bandes RFID (12) à la tête d'essai (14) ; et
des moyens destinés à déplacer chaque sonde d'essai (16) de manière transversale par rapport à la direction de déplacement de la bande continue support (10) à proximité immédiate de la bande RFID (12) correspondante du lot ;
**caractérisé en ce que :**
la matrice de sondes d'essai (16) présente une structure entrelacée par rapport à une pluralité de bandes RFID (12) d'un lot sur la bande continue support (10) et **en ce qu'**un couplage capacitif est établi entre chaque paire d'électrodes d'essai (16a, 16b) dans une sonde d'essai (16) et la paire de plages de bornes (12b, 12c) d'une bande RFID (12) correspondante.

8. Appareil selon la revendication 7, dans lequel la tête d'essai (14) est adaptée de manière à être déplacée contre une face de la bande continue support (10) opposée à une face qui porte les bandes RFID (12), la bande continue (10) étant utilisée en tant que diélectrique.

9. Appareil selon la revendication 7, dans lequel la tête d'essai (14) est adaptée de manière à être déplacée contre une face de la bande continue support (10) qui porte les bandes RFID (12), une feuille diélectrique (20) étant interposée entre chaque paire d'électrodes d'essai (16a, 16b) et une paire correspondante de plages de bornes (12b, 12c).

10. Appareil selon l'une quelconque des revendications 7 à 9, dans lequel chaque sonde d'essai (16) comprend un circuit d'adaptation avec au moins un élément capacitif (C_{MATCH}) et un élément inductif (L_{MATCH}) destiné à une adaptation capacitive et inductive avec un circuit équivalent représenté par chaque bande RFID (12).
